# EUROPÄISCHE PATENTSCHRIFT

(11) **EP 1 821 509 B1**
(45) Veröffentlichungstag und Bekanntmachung des Hinweises auf die Patenterteilung: **20.11.2019**
(21) Anmeldenummer: 07100078.0
(22) Anmeldetag: 03.01.2007
(51) Int. Cl.: H04N 1/00

(54) **Vorrichtung, Mikroskop mit Vorrichtung und Verfahren zum Kalibrieren eines Photosensor-Chips**
Device, microscope with device and method for calibrating a photo sensor chip
Dispositif, microscope doté d'un dispositif et procédé de calibrage d'une puce photosensible

(30) Priorität: 07.01.2006 DE 102006000976
(43) Veröffentlichungstag der Anmeldung: 22.08.2007
(73) Patentinhaber: Leica Microsystems CMS GmbH, 35578 Wetzlar (DE)
(72) Erfinder: Seyfried, Volker, 69226 Nußloch (DE); Schreiber, Frank, 72574 Bad Urach (DE)
(74) Vertreter: Stamer, Harald

(56) Entgegenhaltungen:
- EP-A- 1 688 960
- WO-A-91/18470
- DE-A1- 10 228 477
- DE-A1- 10 253 609
- DE-T2- 69 828 099
- COATES C G ET AL: "BACK-ILLUMINATED ELECTRON MULTIPLYING TECHNOLOGY: THE WORLD'S MOST SENSITIVE CCD FOR ULTRA LOW-LIGHT MICROSCOPY" PROCEEDINGS OF THE SPIE, SPIE, BELLINGHAM, VA, US, Bd. 4962, Nr. 1, 2003, Seiten 319-328, XP002365052 ISSN: 0277-786X
- FOWLER K R: "AUTOMATIC GAIN CONTROL FOR IMAGE-INTENSIFIED CAMERA" IEEE TRANSACTIONS ON INSTRUMENTATION AND MEASUREMENT, IEEE SERVICE CENTER, PISCATAWAY, NJ, US, Bd. 53, Nr. 4, August 2004 (2004-08), Seiten 1057-1069, XP001221374 ISSN: 0018-9456

## Beschreibung

Die Erfindung betrifft ein Mikroskop mit einer Vorrichtung zum Kalibrieren eines Photosensor-Chips. Der Photosensor-Chip ist mit einer Vielzahl von lichtempfindlichen Elementen ausgestattet.

Dabei umfasst das Mikroskop mindestens eine Lichtquelle, die einen Beleuchtungslichtstrahl emittiert, der durch die Optik hindurch über eine Scaneinrichtung eine Probe punktweise, punktrasterartig oder zeilenweise beleuchtet. Ferner ist ein dispersives Element vorgesehen, das einen von der Probe ausgehenden Detektionslichtstrahl räumlich spektral aufspaltet und auf einen lichtempfindlichen Bereich eines Photosensor-Chips richtet.

Des weiteren betrifft die Erfindung ein Verfahren zum Kalibrieren eines Photosensor-Chips.

Die deutsche Patentanmeldung DE 102 53 609 stellt ein Scanmikroskop dar, das einen in einem Detektionsstrahlengang angeordneten Detektor zum Empfangen von von einer Probe ausgehendem Detektionslicht aufweist. Zwischen der Probe und dem Detektor ist ein optisches Verschlussmittel angeordnet, mit dem der Detektionsstrahlengang blockierbar ist. Es ist ein Steuerungsmittel zur Steuerung des Verschlussmittels vorgesehen. Der Detektionsstrahlengang ist automatisch außerhalb des Scanvorgangs und bei zu hoher Detektionslichtleistung blockierbar.

Die U.S.-Patentanmeldung 2003/0223531 offenbart die Kontrolle der Signalverstärkung bei einem Ladungsvervielfachungsdetektor bzw. bei einem CMD (Charge Multiplying Device) mit hoher Präzision. Das CMD besitzt eine Vielzahl von Abschnitten, von denen jeder wieder ein CMD darstellt, so dass damit eine Landungsmultiplikation durchführbar ist.

Die deutsche Patentschrift DE 100 38 526 offenbart ein Verfahren und eine Anordnung in der Fluoreszenzmikroskopie, insbesondere der Laser-Scanning-Mikroskopie, der Fluoreszenz-Korrelationsspektroskopie und der Scanning-Nahfeldmikroskopie, zur Untersuchung von vorwiegend biologischen Proben, Präparaten und zugehörigen Komponenten. Durch den Übergang von der Detektion von wenigen breiten spektralen Farbstoff-Fluoreszenzbändern zur simultanen Aufnahme kompletter Spektren eröffnen sich neue Möglichkeiten bei der Identifikation, Separation und Zuordnung der meist analytischen oder funktionalen Probeneigenschaften zu räumlichen Teilstrukturen oder dynamischen Prozessen. Simultan-Untersuchungen von Proben mit Mehrfachfluorophoren werden damit bei überlappenden Fluoreszenzspektren auch in räumlichen Strukturen bei dicken Proben möglich. Die Datenaufnahmerate wird durch die Anordnung nicht verringert.

Die deutsche Übersetzung DE 690 32 582 T2 eines europäischen Patents offenbart eine Silizium-Lawinenphotodiodenmatrix, welche einen Körper aus Siliziumhalbleitermaterial des n-Typs umfasst, der in sich durch Neutronenumwandlungsdotierung gleichmäßig verteilten Phosphor aufweist. Der spezifische Widerstand weist über wenigstens einen aktiven Bereich eine maximale Abweichung von 0,5% auf. Der Körper besitzt eine erste und eine zweite gegenüberliegende Oberfläche, die eine Strahlungseingangsoberfläche einschließen, und die durch eine seitliche Oberfläche voneinander getrennt sind. Ferner ist ein p-n Übergang vorgesehen, der sich zwischen den Oberflächen erstreckt, wobei die seitliche Oberfläche zur Maximierung der Durchbruchspannung abgeschrägt ist. Eine Vielzahl von Signalkontakten, die auf der ersten Körperoberfläche angeordnet sind, bilden die einzelnen Photodioden. Ferner ist eine gemeinsame Elektrode vorgesehen, die auf der zweiten Körperoberfläche angeordnet ist. Ebenso ist ein Mittel zum Auslesen von Signalen aus den Signalkontakten vorgesehen.

Die deutsche Übersetzung DE 692 31 482 T2 eines europäischen Patents offenbart einen CCD-Bildsensor mit kleinen Pixeln. Bisher hat auf diesem Gebiet die zunehmende Nachfrage auf dem Verbrauchermarkt, CCD-Kameras mit immer höherer Auflösung zu liefern, erfordert, dass die Entwickler die Anzahl der Pixel der CCD-Bildsensoren erhöhen, die in diesen Produkten verwendet werden. Zur gleichen Zeit erforderte der Wettbewerbsdruck, sowohl den Preis dieser Sensoren zu halten oder zu verringern, als auch die Verminderung der Chipgröße, und folglich eine Verkleinerung der aktiven Pixel-Fläche zu bewirken. Dies führt jedoch zu zwei Hauptproblemen: der Verminderung der Empfindlichkeit des Bildsensors, und der Verminderung des Rauschabstandes. Die Empfindlichkeit der Bildsensoren ist proportional zur Pixel-Fläche, dem Aperturwirkungsgrad, dem Quantenwirkungsgrad, der Integrierzeit und dem Ladungs-Spannungs-Umsetzungsfaktor. Die maximale Sensorempfindlichkeit gegenwärtiger Bildsensoren wird normalerweise durch den Störpegel der Ladungserfassungsverstärker bestimmt, die die gesammelte Ladung in eine Ausgangsspannung umsetzen. Ohne diese Beschränkung würde es möglich sein, die einzelnen Photonen zu erfassen, und folglich einen Photonen-Zählbetrieb zu erreichen, der maximalen Fähigkeit eines Bildsensors, die durch die grundlegenden Gesetze der Physik bestimmt ist.

Das britische Schutzrecht GB 2 348 070 offenbart einen Photokatoden-CCD-Sensor mit einem separaten Hochfeld-Multiplikationsregister. Die bildgebende Einrichtung ist geeignet, um Photonen zu zählen, oder für Anwendungen bei niedrigen Lichtverhältnissen. Die Vorrichtung umfasst einen CCD-Sensor, der derart angeordnet ist, dass er die Elektronen empfängt, die von einer Photokatode emittiert werden. Das CCD-Bauteil umfasst ein separates Hochfeld-Multiplikationsregister, in welches Signale von einem Ausgaberegister übertragen werden. Damit soll ein verbessertes Signalrauschverhältnis und eine verbesserte Auflösung erreicht werden.

Die deutsche Patentanmeldung DE 10 2004 003 993 zeigt eine Vorrichtung zum Nachweis von Photonen eines Lichtstrahls, der von einer räumlich begrenzten Quelle ausgeht, insbesondere zum Einsatz in einem Fluoreszenzmikroskop. Dazu ist eine Detektionseinrichtung zur Erhöhung der maximalen Zählrate vorgesehen, die von der Detektionseinrichtung verarbeitet werden kann. Die Detektionseinrichtung umfasst mindestens zwei Detektoren. Im Strahlengang des Lichtstrahls ist ein Bauteil vorgesehen, mit dem der Lichtstrahl derart aufgespalten wird, dass die Photonen zum Zwecke des Nachweises auf die Detektoren verteilt werden.

Bei EMCCD-Chips werden in der photoaktiven Fläche durch Licht generierte Elektronen in einem Verstärkerregister nachverstärkt, bevor sie ausgelesen werden. Die Verstärkung dieses Verstärkungsregisters hängt von verschiedenen Parametern, wie Spannung, Temperatur, Zeit, etc. in komplexer Weise ab. Die gewonnenen Daten über die Beleuchtungsintensität der EMCCD-Chips sind entsprechend schwierig zu beurteilen. Probleme treten bereits dann auf, wenn der EMCCD-Chip nur ein einziges Verstärkungsregister besitzt (was der Normalfall ist), und mehrere nacheinander durchgeführte Messungen miteinander vergleichbar sein sollen. Besonders heftige Probleme treten insbesondere dann auf, wenn der EMCCD-Chip mehrere Verstärkungsregister besitzt, die sich auf Grund verschiedener Ursachen unterschiedlich verhalten können.

Die DE 102 28477 A1 beschreibt eine Vorrichtung und ein Verfahren zum Kalibrieren eines Spektraldetektors, insbesondere auch für ein konfokales Scanmikroskop. Zum Kalibrieren wird Licht einer Referenzlichtquelle bekannter spektraler Zusammensetzung in den Detektionsstrahlengang eingekoppelt. Hierzu wird eine Hülse mit einer das Referenzlicht führenden Lichtleitfaser auf das Objektiv aufgesetzt.

Aus der WO 91/18470 ist eine Korrekturschaltung zur Ermittlung von Korrekturwerten zum Ausgleich von Variationen in der Ausgabe eines Photodetektors mit mehreren Pixeln bekannt. Dabei wird den jeweiligen Korrekturwerten vor der weiteren Verarbeitung ein logarithmischer Wert zugewiesen. Die Korrekturwerte werden dann in der Folge verwendet, um die gemessenen Bildwerte zu korrigieren.

Der Erfindung liegt die Aufgabe zugrunde, ein Mikroskop zu schaffen, das eine Vorrichtung zum Kalibrieren eines Photosensor-Chips umfasst, damit das Einstellen bzw. Regeln geeigneter Parameter das Verstärkungsverhalten eines Verstärkungsregisters zeitlich konstant hält. Ebenso soll es möglich sein, die durch das Verstärkungsverhalten der durch das Verstärkungsregister bedingten Effekte dadurch zu korrigieren, dass eine nachträgliche Bearbeitung der aufgenommenen Daten durchgeführt wird.

Die objektive Aufgabe wird durch ein Mikroskop gelöst, das die Merkmale des Anspruchs 1 umfasst.

Zusätzlich liegt der Erfindung die Aufgabe zugrunde, ein Verfahren zu schaffen, mit dem durch Einstellen geeigneter Parameter das Verstärkungsverhalten eines Verstärkungsregisters zeitlich konstant gehalten werden kann, oder das Verstärkungsverhalten mehrerer Verstärkungsregister aufeinander abgeglichen werden kann. Ebenso soll es möglich sein, die durch das Verstärkungsverhalten eines durch das Verstärkungsregister bedingten relevanten Effekte durch nachträgliche Bearbeitung der aufgenommenen Daten zu korrigieren.

Die objektive Aufgabe wird durch ein Verfahren gelöst, das die Merkmale des Patentanspruchs 20 aufweist. Zum Kalibrieren ist es vorteilhaft, wenn eine Referenzlichtquelle vorgesehen ist, die Licht auf zumindest einen Teil des Photosensor-Chips richtet. Ferner ist eine Steuer- bzw. Regeleinheit vorgesehen, die Varianzen zwischen den einzelnen lichtempfindlichen Elementen bestimmt und korrigiert.

Die Referenzlichtquelle beleuchtet alle lichtempfindlichen Elemente des Photosensor-Chips. Ebenso ist es denkbar, dass die Referenzlichtquelle eine begrenzte Zahl der lichtempfindlichen Elemente des Photosensor-Chips beleuchtet. Die begrenzte Zahl der lichtempfindlichen Elemente des Photosensor-Chips sind diejenigen lichtempfindlichen Elemente, die für die eigentliche Messung keinen Beitrag leisten.

Die Referenzlichtquelle definiert einen Referenzstrahlengang, und ebenso ist auf dem Photosensor-Chip ein Detektionsstrahl gerichtet, wobei der Detektionsstrahlengang und der Referenzstrahlengang teilweise identisch sind.

Ebenso ist es vorstellbar, dass der Detektionsstrahlengang und der Referenzstrahlengang räumlich voneinander getrennt sind. Im Referenzstrahlengang kann zusätzlich ein Filterrad vorgesehen sein. Ebenso ist es denkbar, eine Maske im Referenzstrahlengang vorzusehen, um ausgewählte lichtempfindliche Elemente des Photosensor-Chips zu beleuchten. Das ausgewählte Beleuchten lichtempfindlicher Elemente des Photosensor-Chips kann ebenso durch ein Array aus mikroelektronischen Spiegeln (MEMS) erreicht werden. Die Referenzlichtquelle kann als Punktlichtquelle ausgebildet sein. Ebenso ist es denkbar, dass der Referenzlichtquelle eine Lochblende nachgeschaltet ist, um dadurch eine Punktlichtquelle zu erzeugen. Die Lochblende kann als fixe Blende oder als variable Blende ausgebildet sein.

Die Referenzlichtquelle ist derart an- und ausschaltbar, dass entweder nur Licht des Detektionsstrahlengangs, oder nur Licht des Referenzstrahlengangs auf den Photosensor-Chip fällt. Die Referenzlichtquelle kann über die Steuer- bzw. Regeleinheit ein- und ausschaltbar sein. Ein schaltbares Filter kann vorgesehen sein, mit dem über die Steuer- bzw. Regeleinheit die Lichtstärke des Referenzlichts einstellbar ist Das schaltbare Filter ist ein akustooptisches Element, ein elektrooptisches Element oder ein Flüssigkristall-Display.

Die Steuer- bzw. Regeleinheit führt eine Korrektur der unterschiedlichen Verstärkungen der lichtempfindlichen Elemente des Photosensor-Chips durch. Diese Korrektur wird nach der Verstärkung des Signals von den lichtempfindlichen Elementen des Photosensor-Chips durchgeführt.

Ebenso ist es denkbar, dass die Steuer- bzw. Regeleinheit eine Korrektur der unterschiedlichen Verstärkungen der lichtempfindlichen Elemente des Photosensor-Chips durch individuelle Regelung der Verstärkung des Signals von den lichtempfindlichen Elementen des Photosensor-Chips durchführt.

Ein Mikroskop ist mit mindestens einer Lichtquelle versehen, die einen Beleuchtungslichtstrahl emittiert, der durch die Optik hindurch über eine Scaneinrichtung eine Probe punktweise, punktrasterartig oder zeilenweise beleuchtet. Es ist ein dispersives Element vorgesehen, das einen von der Probe ausgehenden Detektionslichtstrahl räumlich aufspaltet, und auf einen lichtempfindlichen Bereich eines Photosensor-Chips richtet. Zusätzlich ist im Mikroskop eine Referenzlichtquelle vorgesehen, die Licht auf zumindest einen Teil des Photosensor-Chips richtet. Ebenso ist eine Steuer- bzw. Regeleinheit vorgesehen, die Varianzen zwischen den einzelnen lichtempfindlichen Elementen bestimmt und korrigiert.

Vorteilhaft ist auch ein Verfahren zum Kalibrieren eines Photosensor-Chips, der eine Vielzahl von lichtempfindlichen Elementen umfasst. Durch eine Referenzlichtquelle wird ein Referenzlichtstrahl emittiert. Der Referenzlichtstrahl ist auf zumindest einen Teil des Photosensor-Chips gerichtet. Ferner ist eine Steuer- bzw. Regeleinheit vorgesehen, durch die Varianzen zwischen den einzelnen lichtempfindlichen Elementen bestimmt und korrigiert werden.

Weitere vorteilhafte Ausgestaltungen der Erfindung können den Unteransprüchen entnommen werden.

In der Zeichnung ist der Erfindungsgegenstand schematisch dargestellt, und wird anhand der Figuren nachfolgend beschrieben. Dabei zeigen:
- Fig. 1: eine schematische Darstellung eines Scanmikroskops mit einem Photosensor-Chip zum Aufnehmen der Signale des Detektionslichts;
- Fig. 2: eine schematische Darstellung des Strahlengangs nach der Detektionslichtblende, wobei die Lichtstärke des Referenzlichts mit einem Filterrad eingestellt wird;
- Fig. 3: eine schematische Darstellung des Strahlengangs nach der Detektionslichtblende, wobei der Detektionsstrahlengang und der Referenzstrahlengang teilweise identisch verlaufen;
- Fig. 4: eine schematische Darstellung eines Detektorarrays, wie es bei einem Photosensor-Chip gemäß der vorliegenden Erfindung verwendet wird.

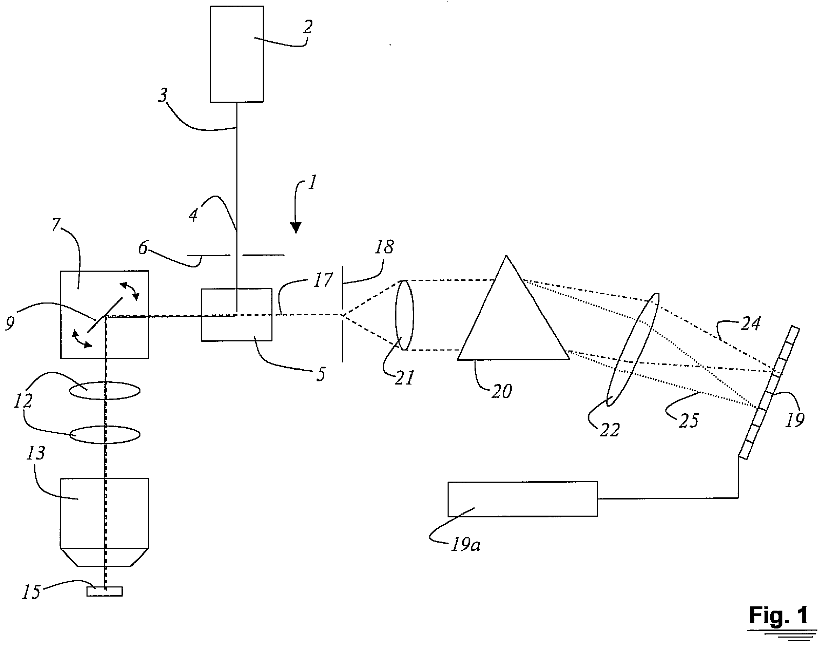

Fig. 1 zeigt den schematischen Aufbau eines Laserscanmikroskops 1. Der von mindestens einem Beleuchtungssystem 2 kommende Beleuchtungslichtstrahl 3 wird von einem Strahlteiler oder einem geeigneten Umlenkmittel 5 zu einer Scaneinrichtung 7 geleitet. Bevor der Beleuchtungslichtstrahl 3 auf das Umlenkmittel 5 trifft, passiert dieser ein Beleuchtungspinhole 6. Die Scaneinrichtung 7 umfasst mindestens einen Scanspiegel 9, der den Beleuchtungslichtstrahl 3 durch eine Scanoptik 12 und eine Mikroskopoptik 13 hindurch über bzw. durch ein Objekt 15 führt. Der Beleuchtungslichtstrahl 3 wird bei nicht transparenten Objekten 15 über die Objektoberfläche geführt. Bei biologischen Objekten 15 (Präparaten) oder transparenten Objekten kann der Beleuchtungslichtstrahl 3 auch durch das Objekt 15 geführt werden. Zu diesem Zweck werden nichtleuchtende Präparate ggf. mit einem geeigneten Farbstoff markiert (nicht dargestellt, da etablierter Stand der Technik). Die in dem Objekt 15 vorhandenen Farbstoffe werden durch den Beleuchtungslichtstrahl 3 angeregt, und senden Licht in einem ihnen eigenen charakteristischen Bereich des Spektrums aus. Dieses vom Objekt 15 ausgehende Licht definiert einen Detektionslichtstrahl 17. Dieser gelangt durch die Mikroskopoptik 13, die Scanoptik 12 und über die Scaneinrichtung 7 zum Umlenkmittel 5, passiert dieses und gelangt über ein Detektionspinhole 18 auf mindestens einen Photosensor-Chip 19, der als CCD-Chip, EMCCD-Chip, APD-Array oder PMT-Array ausgeführt ist. Der vom Objekt ausgehende bzw. definierte Detektionslichtstrahl 17 ist in Fig. 1 als gestrichelte Linie dargestellt. Im Photosensor-Chip 19 werden elektrische, zur Leistung des vom Objekt 15 ausgehenden Lichtes weitgehend proportionale Detektionssignale erzeugt. Da, wie bereits oben erwähnt, vom Objekt 15 Licht nicht nur einer Wellenlänge ausgesandt wird, ist es sinnvoll, vor dem Photosensor-Chip 19 ein dispersives Element 20 anzuordnen. Das dispersive Element 20 spaltet den Detektionslichtstrahl spektral auf, so dass die einzelnen Wellenlängen des Detektionslichts räumlich spektral getrennt werden. Dem dispersiven Element 20 ist ein Linse 21 vorgeschaltet, die den Detektionslichtstrahl 17 parallelisiert. Dem dispersiven Element 20 ist eine weitere Linse 22 nachgeschaltet, die die spektral getrennten Strahlen 24, 25 des Detektionslichtstrahls 17 auf den Photosensor-Chip 19 fokussiert. Die spektral getrennten Strahlen 24, 25 unterscheiden sich hinsichtlich der Wellenlänge und treffen somit auf unterschiedliche Bereiche auf dem Photosensor-Chip 19.

Um ein optimales Verhalten eines EMCCD-Chips zu erzielen, muss die Verstärkung der Register an die Beleuchtungsstärke und die Beleuchtungsdauer auf dem EMCCD-Chip angepasst werden. Hierfür kann die Verstärkungsspannung an den verschiedenen Registern des Photosensor-Chips 19 variiert werden. Die Verstärkung der Ladungen beim Durchlaufen der Verstärkerstrecke ist aber nicht nur abhängig von der Verstärkerspannung, sondern auch von der Temperatur. Außerdem treten z.B. durch Fertigungstoleranzen Variationen in der Verstärkung bei unterschiedlichen Verstärkerregistern auf. Besondere Schwierigkeiten resultieren daraus, dass die Temperaturabhängigkeit der Verstärkung bei verschiedenen Verstärkern unterschiedlich ist. Die Verstärkungsregister des Photosensor-Chips 19 können sich verschieden verhalten, was folgende Ursachen haben kann: bei gleicher Grundeinstellung können die verschiedenen Verstärkungsregister wegen der Fertigungstoleranzen unterschiedliche Verstärkung aufweisen, ebenso kann die Verstärkungsspannung von Verstärkungsregister zu Verstärkungsregister schwanken. Eine weitere Beeinflussung kann sein, dass die Temperatur entlang des Photosensor-Chips schwankt. Ebenso führen Änderungen der lokalen Temperatur auf dem Photosensor-Chip (Temperaturgradient über dem Photosensor-Chip) zu einer unterschiedlichen Verstärkung. Alterungseffekte des Photosensor-Chips können ebenfalls die Verstärkung der einzelnen Verstärkungsregister beeinflussen, und Veränderungen der sonstigen Umweltbedingungen haben ebenfalls einen negativen Effekt auf eine homogene Verstärkung der einzelnen Verstärkungsregister. Die zu erwartenden Schwankungen und Abhängigkeiten sind deutlich höher als z.B. bei Photomultipliern. Ein quantitativer Vergleich ist zwischen den Ausgangssignalen zweier unterschiedlicher Register, bzw. ein und desselben Registers bei zwei aufeinanderfolgenden Messungen bei z.B. unterschiedlichen Temperaturen sehr schwierig. Probleme treten insbesondere auf, wenn ein EMCCD-Chip mit mehreren Verstärkungsregistern ausgerüstet ist, und die Applikation eine identische Verstärkung aller Signale verlangt. Ähnliche Probleme, wie oben erwähnt, treten auch bei APD-Arrays oder Photomultiplier-Arrays auf. Mit Hilfe der Steuer- bzw. Regeleinheit 19a werden all diese negativen Einflüsse detektiert, und die unterschiedlichen Verstärkungen der Verstärkungsregister abgeglichen.

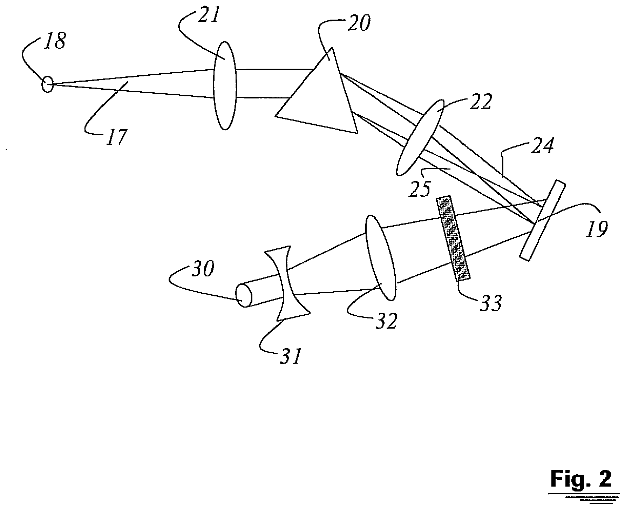

Fig. 2 zeigt eine Ausführungsform des Strahlengangs in einem Laserscanmikroskop nach der Detektionslochblende 18. Wie bereits vorstehend erwähnt, wird das Detektionslicht von der Detektionslochblende 18 durch ein optisches Element 21 auf ein dispersives Element 20 abgebildet. Das dispersive Element 20 ist in diesem Fall ein Prisma. Das dispersive Element 20 spaltet das Detektionslicht spektral auf. Mit einem weiteren optischen Element 22 wird das Detektionslicht auf einen Photosensor-Chip 19 abgebildet, wobei die unterschiedlichen spektralen Anteile des Detektionslichts auf unterschiedliche Bereiche des Photosensor-Chips 19 abgebildet werden. Der Photosensor-Chip 19 kann z.B. ein EMCCD-Chip, ein APD-Array oder ein PMT-Array sein. Das dispersive Element 20 kann ein Prisma, ein Gitter, ein holographisches Element, etc. sein. Durch das optische Element 22 werden, wie bereits erwähnt, die unterschiedlichen spektralen Anteile des Detektionslichts räumlich aufgespalten, so dass diese auf unterschiedliche Stellen des Photosensor-Chips 19 treffen. Durch Auslesen des Photosensor-Chips 19 erhält man dann direkt das Spektrum des Beleuchtungslichts. Man kann aber auch durch eine geeignete Auswertung der gewonnenen Daten die Lichtintensität in bestimmten, ausgewählten spektralen Bändern bestimmen. Dies geht jedoch nur dann hinreichend gut, wenn es keine Veränderung der Verstärkung des Photosensor-Chips 19 über der Zeit gibt. Ferner ist Bedingung, dass unterschiedliche Pixel oder Elemente des Photosensor-Chips 19 sich gleich bzw. ähnlich verhalten. Um die unbekannte Verstärkung eines einzelnen oder mehrerer unterschiedlicher Verstärkungsregister des Photosensor-Chips 19 zu bestimmen und auszugleichen, genügt es eine Referenzmessung bei bekannter Beleuchtungsstärke durchzuführen. Hierzu müssen mehrere Pixel oder Elemente des Photosensor-Chips 19, die unterschiedlichen Verstärkungsregistern zugeordnet sind, vorzugsweise gleichzeitig mit einer gleichen Beleuchtungsintensität beaufschlagt werden. Auch eine unterschiedliche Beleuchtungsintensität ist möglich, wenn die Unterschiede entweder bekannt sind oder sich nicht zeitlich ändern. Zur Beaufschlagung der Pixel oder Elemente des Photosensor-Chips 19 ist in der in Fig. 2 dargestellten Ausführungsform eine Referenzlichtquelle 30 vorgesehen. Die Referenzlichtquelle 30 kann z.B. mit Hilfe einer LED, einer Laserdiode, einer Glühbirne, einer Entladungslampe, etc. realisiert werden. Insbesondere ist eine schnell schaltbare Referenzlichtquelle 30, wie z.B. eine LED oder eine Laserdiode von Vorteil, da damit die Beleuchtung für die Kalibrierung auf die wenigen, für die Kalibrierung relevanten Zeitpunkte begrenzt werden kann. Der Referenzlichtquelle 30 ist ein optisches System 31, 32 nachgeschaltet, das das Referenzlicht 40 auf den Photosensor-Chips 19 abbildet. Zwischen dem Photosensor-Chip 19 und dem optischen System 31, 32 ist ein schaltbares Filter 33 vorgesehen, mit dem die Lichtstärke des Referenzlichts 40 eingestellt werden kann. Das schaltbare Filter 33 kann z.B. ein akustooptisches Element, bzw. ein elektrooptisches Element oder ein LCD, etc. sein. In der in Fig. 2 dargestellten Ausführungsform sind der Detektionslichtstrahl 17 und der Referenzlichtstrahl räumlich voneinander getrennt. Die Beleuchtung des Photosensor-Chips 19 für die Referenzmessung kann z.B. vor oder nach der eigentlichen Messung erfolgen. Ebenfalls ist es denkbar, dass die Referenzmessung während des Rücklaufs, oder in den Umkehrpunkten des Scanners bzw. eines Scanspiegels 9 erfolgt. Bei der Referenzmessung vor oder nach der eigentlichen Messung können somit auch größere Bereiche des Photosensor-Chips 19 beleuchtet werden. Dabei können auch Bereiche beleuchtet werden, die während der eigentlichen Messung für das Detektionslicht benötigt werden. Wie bereits vorstehend erwähnt, muss das Licht der Referenzlichtquelle 30 für die Referenzmessung an- und ausschaltbar sein. Ebenso ist es denkbar, dass während der eigentlichen Messung auch die Referenzmessung erfolgt. Hierbei werden dann folglich nur Bereiche des Photosensor-Chips 19 beleuchtet, die für die eigentliche Messung nicht benötigt werden. Hierbei ist zu beachten, dass für jedes Verstärkungsregister ihm zugeordnete Bereiche für die Referenzmessung beleuchtet werden.

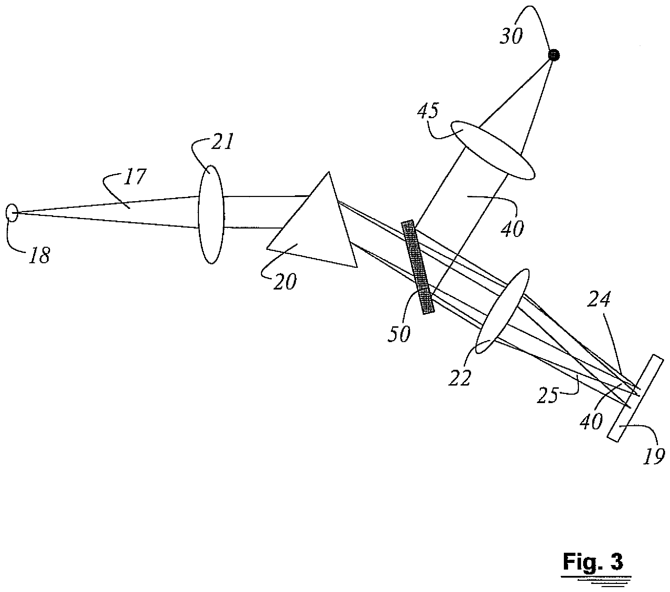

Fig. 3 zeigt eine weitere Ausführungsform der vorliegenden Erfindung, bei der der Detektionsstrahlengang 17 und der Referenzstrahlengang 40 teilweise identisch sind. Dem dispersiven Element 20 ist ein Einkoppelelement 50 nachgeordnet, mit dem der Referenzstrahlengang 40 in den Detektionsstrahlengang 17 eingekoppelt wird. Dabei treffen dann der Referenzstrahlengang 40 und die durch das dispersive Element spektral aufgespaltenen Strahlengänge 24 und 25 auf unterschiedliche Bereiche des photosensitiven Elements 19. Der von der Referenzlichtquelle ausgehende Referenzlichtstrahl wird durch eine Linse 45 parallelisiert. Die Linse 45 kann alternativ als Zylinderlinse ausgeführt sein. Mit der in Fig. 3 vorgeschlagenen Anordnung wird eine begrenzte Zahl von Pixeln auf dem Photosensor-Chip 19 beleuchtet. Für die Beleuchtung mit dem Referenzlichtstrahl werden Pixel bevorzugt, die für die eigentliche Messung nicht benötigt werden.

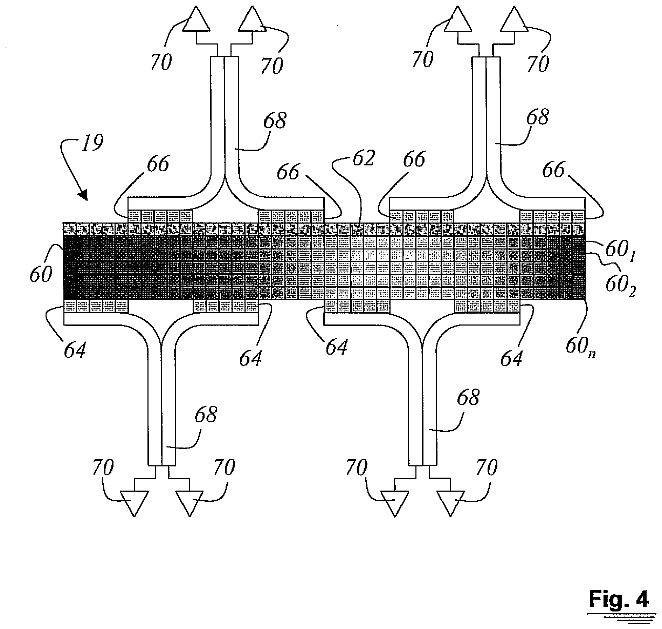

Fig. 4 zeigt eine schematische Ansicht des Photosensor-Chips 19. Der Photosensor-Chip 19 weist eine optisch sensitive Fläche 60 auf, die aus mehreren Zeilen 60₁, 60₂, ... , 60ₙ aufgebaut ist. In der hier dargestellten Ausführungsform schließt sich an die optisch sensitive Fläche 60 mindestens eine Zeile 62 an, die für eine Referenzmessung herangezogen werden kann. An die optisch sensitive Fläche 60 schließen sich mehrere Summierungselemente 64 an. Ebenso schließen sich an die Zeile für die Referenzmessung 62 mehrere Summierungselemente 66 an. Der Inhalt der Summierungselemente 64 wird entsprechenden Verstärkerregistern 68 zugeführt. Ebenso werden die Inhalte der Summierungselemente 66 mehreren Verstärkungsregistern 68 zugeführt. Der Ausgang der jeweiligen Verstärkungsregister 68 gelangt zu den entsprechenden Ausgangsverstärkern 70. Wie bereits erwähnt existieren für die Referenzmessung zwei alternative Verfahren.

Bei dem ersten Verfahren erfolgt die Referenzmessung vor oder nach der eigentlichen Messung. In diesem Fall können auch größere Bereiche des Photosensor-Chips beleuchtet werden. Dies kann z.B. auch die gesamte optisch sensitive Fläche 60 des Photosensor-Chips 19 sein. Folglich ist für diese Messung das Licht der Lichtquelle entsprechend an- bzw. ausschaltbar. Die Daten der Referenzmessung werden über die entsprechenden Summierelemente 64 und 66 den entsprechenden Verstärkungsregistern 68 zugeführt.

Bei einem zweiten möglichen Verfahren erfolgt die Referenzmessung während der eigentlichen Messung. Hierbei werden natürlich nur Bereiche der optisch sensitiven Fläche 60 des Photosensor-Chips 19 beleuchtet, die für die eigentliche Messung nicht benötigt werden. Dabei wird z.B. eine Zeile 62 für die Referenzmessung beleuchtet. Es ist dabei zu beachten, dass diejenigen Bereiche des Photosensor-Chips 19 zu beleuchten sind, die jenen Verstärkungsregisten zugeordnet sind, für die die Referenzmessung durchgeführt werden soll.

## Patentansprüche

1. Konfokales Scanmikroskop (1) mit mindestens einer Lichtquelle (3), die einen Beleuchtungslichtstrahl (5) emittiert, der durch die Optik (9) hindurch über eine Scaneinrichtung eine Probe (10) punktweise, punktrasterartig oder zeilenweise beleuchtet, einem dispersiven Element (20), das einen von der Probe (10) ausgehenden Detektionslichtstrahl (12) räumlich spektral aufspaltet und auf einen lichtempfindlichen Bereich eines Photosensor-Chips (19) richtet, **dadurch gekennzeichnet, dass** eine Referenzlichtquelle (30) vorgesehen ist, die Licht auf zumindest einen Teil des Photosensor-Chips richtet, und dass eine Steuer- bzw. Regeleinheit vorgesehen ist, die Varianzen zwischen den einzelnen lichtempfindlichen Elementen bestimmt und korrigiert, wobei entweder die Steuer- und Regeleinheit derart ausgestaltet ist, dass die Referenzmessung während eines Rücklaufs oder in Umkehrpunkten der Scaneinrichtung erfolgt, oder die Referenzlichtquelle eine begrenzte Zahl der lichtempfindlichen Elemente des Photosensor-Chips beleuchtet, welche für die eigentliche Messung keinen Beitrag leisten.

2. Mikroskop (1) nach Anspruch 1, **dadurch gekennzeichnet, dass** die Referenzlichtquelle alle lichtempfindlichen Elementen des Photosensor-Chips beleuchtet.

3. Mikroskop (1) nach einem der Ansprüche 1 bis 2, **dadurch gekennzeichnet, dass** die Referenzlichtquelle einen Referenzstrahlengang definiert, und auf den Photosensor-Chip ein Detektionsstrahl gerichtet ist, wobei der Detektionsstrahlengang und der Referenzstrahlengang teilweise identisch sind.

4. Mikroskop (1) nach einem der Ansprüche 1 bis 2, **dadurch gekennzeichnet, dass** die Referenzlichtquelle einen Reforünzstrahlengang definiert, und auf den Photosensor-Chip ein Detektionsstrahl gerichtet ist, wobei der Detektionsstrahlengang und der Referenzstrahlengang räumlich getrennt sind.

5. Mikroskop (1) nach Anspruch 4 **dadurch gekennzeichnet, dass** ein Filterrad im Referenzstrahlengang vorgesehenen ist.

6. Mikroskop (1) nach einem der Ansprüche 1 bis 4, **dadurch gekennzeichnet, dass** eine Maske im Referenzstrahlengang vorgesehen ist, um ausgewählte lichtempfindliche Elemente des Photosensor-Chips zu beleuchten.

7. Mikroskop (1) nach einem der Ansprüche 1 bis 6, **dadurch gekennzeichnet, dass** die Referenzlichtquelle eine Punktlichtquelle ist.

8. Mikroskop (1) nach einem der Ansprüche 1 bis 6, **dadurch gekennzeichnet, dass** eine Lochblende der Referenzlichtquelle nachgeschaltet ist, um eine punktförmige Lichtquelle zu erzeugen.

9. Mikroskop (1) nach Anspruch 8, **dadurch gekennzeichnet, dass** die Lochblende eine feste Lochblende ist.

10. Mikroskop (1) nach Anspruch 8, **dadurch gekennzeichnet, dass** die Lochblende eine variable Lochblende ist.

11. Mikroskop (1) nach einem der Ansprüche 1 bis 10, **dadurch gekennzeichnet, dass** das Licht der Referenzlichtquelle derart an- und ausschaltbar ist, dass entweder nur Licht des Detektionsstrahlengangs oder nur Licht des Referenzstrahlengangs auf den Photosensor-Chip fällt.

12. Mikroskop (1) nach einem der Ansprüche 1 bis 11, **dadurch gekennzeichnet, dass** das Licht der Referenzlichtquelle über die Steuer- bzw. Regeleinheit ein- und ausschaltbar ist.

13. Mikroskop (1) nach Anspruch 12, **dadurch gekennzeichnet dass** die Referenzlichtquelle eine LED oder Laserdiode ist.

14. Mikroskop (1) nach einem der Ansprüche 1 bis 13, **dadurch gekennzeichnet, dass** ein schaltbares Filter vorgesehen ist, mit dem über die Steuer- bzw. Regeleinheit die Lichtstärke des Referenzlichts einstellbar ist.

15. Mikroskop (1) nach Anspruch 14, **dadurch gekennzeichnet, dass** das schaltbare Filter ein akustooptisches Element, ein elektrooptisches Element oder ein Flüssigkristalldisplay ist.

16. Mikroskop (1) nach einem der Ansprüche 1 bis 15, **dadurch gekennzeichnet, dass** die Steuer- bzw. Regeleinheit eine Korrektur der unterschiedlichen Verstärkungen der lichtempfindlichen Elemente des Photosensor-Chips nach der Verstärkung des Signals von den lichtempfindlichen Elemente des Photosensor-Chips durchführt.

17. Mikroskop (1) nach einem der Ansprüche 1 bis 15, **dadurch gekennzeichnet, dass** die Steuer- bzw. Regeleinheit eine Korrektur der unterschiedlichen Verstärkungen der lichtempfindlichen Elemente des Photosensor-Chips durch individuelle Regelung der Verstärkung des Signals von den lichtempfindlichen Elementen des Photosensor-Chips durchführt.

18. Mikroskop (1) nach einem der Ansprüche 1 bis 16, **dadurch gekennzeichnet, dass** der Photosensor-Chip ein EMCCD mit mehreren Verstärkerregistem, ein EMCCD mit nur einem Verstärkerregister, ein normales CCD, ein CMOS-Chip, ein APD-Array oder ein Multichannelplate ist.

19. Mikroskop (1) nach Anspruch 18, **dadurch gekennzeichnet, dass** der verwendete Photosensor-Chip ein Zeilenarray oder ein Flächenarray ist.

20. Verfahren zum Kalibrieren eines Photosensor-Chips in einem konfokalen Scanmikroskop, der eine Vielzahl von lichtempfindlichen Elementen umfasst, **dadurch gekennzeichnet, dass** durch eine Referenzlichtquelle ein Referenzlichtstrahl emittiert wird, wobei der Referenzlichtstrahl auf zumindest einen Teil des Photosensor-Chips gerichtet wird, und dass eine Steuer- bzw. Regeleinheit vorgesehen ist, durch die Varianzen zwischen den einzelnen lichtempfindlichen Elementen bestimmt und korrigiert werden, wobei entweder die Referenzmessung während eines Rücklaufs oder in Umkehrpunkten der Scaneinrichtung erfolgt, oder durch die Referenzlichtquelle eine begrenzte Zahl der lichtempfindlichen Elemente des Photosensor-Chips beleuchtet werden, die für die eigentliche Messung keinen Beitrag leisten

21. Verfahren nach Anspruch 20, **dadurch gekennzeichnet, dass** durch die Referenzlichtquelle alle lichtempfindlichen Elementen des Photosensor-Chips beleuchtet werden.

22. Verfahren nach einem der Ansprüche 20 bis 21, **dadurch gekennzeichnet, dass** die Referenzlichtquelle einen Referenzstrahlengang definiert, und auf den Photosensor-Chip ein Detektionsstrahl gerichtet wird, wobei der Detektionsstrahlengang und der Referenzstrahlengang teilweise identisch sind.

23. Verfahren nach einem der Ansprüche 20 bis 21, **dadurch gekennzeichnet, dass** die Referenzlichtquelle einen Referenzstrahlengang definiert, und auf den Photosensor-Chip ein Detektionsstrahl gerichtet wird, wobei der Detektionsstrahlengang und der Referenzstrahlengang räumlich getrennt sind.

24. Verfahren nach Anspruch 23, **dadurch gekennzeichnet, dass** ein Filterrad im Referenzstrahlengang vorgesehenen ist.

25. Verfahren nach einem der Ansprüche 20 bis 24, **dadurch gekennzeichnet, dass** eine Maske im Referenzstrahlengang vorgesehen ist, so dass ausgewählte lichtempfindliche Elemente des Photosensor-Chips beleuchtet werden.

26. Verfahren nach einem der Ansprüche 20 bis 24, **dadurch gekennzeichnet, dass** ein Array aus mikroelektronischen Spiegeln im Referenzstrahlengang vorgesehen ist, so dass ausgewählte lichtempfindliche Elemente des Photosensor-Chips beleuchtet werden.

27. Verfahren nach einem der Ansprüche 20 bis 26, **dadurch gekennzeichnet, dass** die Referenzlichtquelle eine Punktlichtquelle ist.

28. Verfahren nach einem der Ansprüche 20 bis 26, **dadurch gekennzeichnet, dass** eine Lochblende der Referenzlichtquelle nachgeschaltet ist, um eine punktförmige Lichtquelle zu erzeugen.

29. Verfahren nach Anspruch 28, **dadurch gekennzeichnet, dass** die Lochblende eine feste Lochblende ist.

30. Verfahren nach Anspruch 25, **dadurch gekennzeichnet, dass** die Lochblende eine variable Lochblende ist.

31. Verfahren nach einem der Ansprüche 20 bis 30, **dadurch gekennzeichnet, dass** das Licht der Referenzlichtquelle derart an- und ausgeschaltet wird, dass entweder nur Licht des Detektionsstrahlengangs oder nur Licht des Referenzstrahlengangs auf den Photosensor-Chip fällt.

32. Verfahren nach einem der Ansprüche 20 bis 31, **dadurch gekennzeichnet, dass** das Licht der Referenzlichtquelle über die Steuer- bzw. Regeleinheit ein- und ausgeschaltet wird.

33. Verfahren nach Anspruch 32, **dadurch gekennzeichnet, dass** die Referenzlichtquelle eine LED oder Laserdiode ist.

34. Verfahren nach einem der Ansprüche 20 bis 33, **dadurch gekennzeichnet, dass** ein schaltbares Filter vorgesehen ist, mit dem über die Steuer- bzw. Regeleinheit die Lichtstärke des Referenzlichts eingestellt wird.

35. Verfahren nach einem der Ansprüche 20 bis 34, **dadurch gekennzeichnet, dass** die Steuer- bzw. Regeleinheit eine Korrektur der unterschiedlichen Verstärkungen der lichtempfindlichen Elemente des Photosensor-Chips nach der Verstärkung des Signals von den lichtempfindlichen Elementen des Photosensor-Chips durchführt.

36. Verfahren nach einem der Ansprüche 20 bis 34, **dadurch gekennzeichnet, dass** die Steuer- bzw. Regeleinheit eine Korrektur der unterschiedlichen Verstärkungen der lichtempfindlichen Elemente des Photosensor-Chips durch individuelle Regelung der Verstärkung des Signals von den lichtempfindlichen Elementen des Photosensor-Chips durchführt.

37. Verfahren nach einem der Ansprüche 20 bis 36, **dadurch gekennzeichnet, dass** der Photosensor-Chip ein EMCCD mit mehreren Verstärkerregistern, ein EMCCD mit nur einem Verstärkerregister, ein normales CCD, ein CMOS-Chip, ein APD-Array oder ein Multichannelplate ist.

38. Verfahren nach Anspruch 37, **dadurch gekennzeichnet, dass** der verwendete Photosensor-Chip ein Zeilenarray oder ein Flächenarray ist.

## Claims

1. Confocal scanning microscope (1) comprising at least one light source (3) that emits an illumination light beam (5) that, passing through the optical unit (9), illuminates a sample (10) point-by-point, in dot-scanning fashion or line-by-line by way of a scanning device, a dispersive element (20) that spatially spectrally splits a detection light beam (12) emanating from the sample (10) and directs said light beam onto a light-sensitive region of a photosensor chip (19), **characterized in that** provision is made of a reference light source (30) that directs light onto at least a portion of the photosensor chip and **in that** provision is made of an open-loop or closed-loop control unit that determines and corrects variations between the individual light-sensitive elements, wherein either the open-loop and closed-loop control unit is configured in such a way that the reference measurement is implemented during a return or at reversal points of the scanning device or the reference light source illuminates a restricted number of the light-sensitive elements of the photosensor chip that do not contribute to the actual measurement.

2. Microscope (1) according to Claim 1, **characterized in that** the reference light source illuminates all light-sensitive elements of the photosensor chip.

3. Microscope (1) according to either of Claims 1 and 2, **characterized in that** the reference light source defines a reference beam path and a detection beam is directed onto the photosensor chip, wherein the detection beam path and the reference beam path are partly identical.

4. Microscope (1) according to either of Claims 1 and 2, **characterized in that** the reference light source defines a reference beam path and a detection beam is directed onto the photosensor chip, wherein the detection beam path and the reference beam path are spatially separated.

5. Microscope (1) according to Claim 4, **characterized in that** a filter wheel is provided in the reference beam path.

6. Microscope (1) according to any one of Claims 1 to 4, **characterized in that** a mask is provided in the reference beam path in order to illuminate selected light-sensitive elements of the photosensor chip.

7. Microscope (1) according to any one of Claims 1 to 6, **characterized in that** the reference light source is a point light source.

8. Microscope (1) according to any one of Claims 1 to 6, **characterized in that** a pinhole stop is disposed downstream of the reference light source in order to produce a punctiform light source.

9. Microscope (1) according to Claim 8, **characterized in that** the pinhole stop is a fixed pinhole stop.

10. Microscope (1) according to Claim 8, **characterized in that** the pinhole stop is a variable pinhole stop.

11. Microscope (1) according to any one of Claims 1 to 10, **characterized in that** the light of the reference light source is able to be switched on and off in such a way that only light of the detection beam path or only light of the reference beam path strikes the photosensor chip.

12. Microscope (1) according to any one of Claims 1 to 11, **characterized in that** the light of the reference light source is able to be switched on and off by way of the open-loop or closed-loop control unit.

13. Microscope (1) according to Claim 12, **characterized in that** the reference light source is an LED or laser diode.

14. Microscope (1) according to any one of Claims 1 to 13, **characterized in that** provision is made of a switchable filter, by means of which the luminous intensity of the reference light is adjustable by way of the open-loop or closed-loop control unit.

15. Microscope (1) according to Claim 14, **characterized in that** the switchable filter is an acousto-optic element, an electro-optic element or liquid crystal display.

16. Microscope (1) according to any one of Claims 1 to 15, **characterized in that** the open-loop or closed-loop control unit carries out a correction of the different gains of the light-sensitive elements of the photosensor chip following the amplification of the signal of the light-sensitive elements of the photosensor chip.

17. Microscope (1) according to any one of Claims 1 to 15, **characterized in that** the open-loop or closed-loop control unit carries out a correction of the different gains of the light-sensitive elements of the photosensor chip by individual closed-loop control of the gain of the signals of the light-sensitive element of the photosensor chip.

18. Microscope (1) according to any one of Claims 1 to 16, **characterized in that** the photosensor chip is an EMCCD comprising a plurality of gain registers, an EMCCD comprising only one gain register, a normal CCD, a CMOS chip, an APD array or a multichannel plate.

19. Microscope (1) according to Claim 18, **characterized in that** the employed photosensor chip is a line array or an area array.

20. Method for calibrating a photosensor chip in a confocal scanning microscope comprising a multiplicity of light-sensitive elements, **characterized in that** a reference light beam is emitted by a reference light source, wherein the reference light beam is directed onto at least a portion of the photosensor chip and **in that** provision is made of an open-loop or closed-loop control unit that determines and corrects variations between the individual light-sensitive elements, wherein either the reference measurement is implemented during a return or at reversal points of the scanning device or the reference light source illuminates a restricted number of the light-sensitive elements of the photosensor chip that do not contribute to the actual measurement.

21. Method according to Claim 20, **characterized in that** all light-sensitive elements of the photosensor chip are illuminated by the reference light source.

22. Method according to either of Claims 20 and 21, **characterized in that** the reference light source defines a reference beam path and a detection beam is directed onto the photosensor chip, wherein the detection beam path and the reference beam path are partly identical.

23. Method according to either of Claims 20 and 21, **characterized in that** the reference light source defines a reference beam path and a detection beam is directed onto the photosensor chip, wherein the detection beam path and the reference beam path are spatially separated.

24. Method according to Claim 23, **characterized in that** a filter wheel is provided in the reference beam path.

25. Method according to any one of Claims 20 to 24, **characterized in that** a mask is provided in the reference beam path such that selected light-sensitive elements of the photosensor chip are illuminated.

26. Method according to any one of Claims 20 to 24, **characterized in that** an array of microelectronic mirrors is provided in the reference beam path such that selected light-sensitive elements of the photosensor chip are illuminated.

27. Method according to any one of Claims 20 to 26, **characterized in that** the reference light source is a point light source.

28. Method according to any one of Claims 20 to 26, **characterized in that** a pinhole stop is disposed downstream of the reference light source in order to produce a punctiform light source.

29. Method according to Claim 28, **characterized in that** the pinhole stop is a fixed pinhole stop.

30. Method according to Claim 25, **characterized in that** the pinhole stop is a variable pinhole stop.

31. Method according to any one of Claims 20 to 30, **characterized in that** the light of the reference light source is switched on and off in such a way that either only light of the detection beam path or only light of the reference beam path strikes the photosensor chip.

32. Method according to any one of Claims 20 to 31, **characterized in that** the light of the reference light source is switched on and off by way of the open-loop or closed-loop control unit.

33. Method according to Claim 32, **characterized in that** the reference light source is an LED or laser diode.

34. Method according to any one of Claims 20 to 33, **characterized in that** provision is made of a switchable filter, by means of which the luminous intensity of the reference light is adjusted by way of the open-loop or closed-loop control unit.

35. Method according to any one of Claims 20 to 34, **characterized in that** the open-loop or closed-loop control unit carries out a correction of the different gains of the light-sensitive elements of the photosensor chip following the amplification of the signal of the light-sensitive elements of the photosensor chip.

36. Method according to any one of Claims 20 to 34, **characterized in that** the open-loop or closed-loop control unit carries out a correction of the different gains of the light-sensitive elements of the photosensor chip by individual closed-loop control of the gain of the signal of the light-sensitive elements of the photosensor chip.

37. Method according to any one of Claims 20 to 36, **characterized in that** the photosensor chip is an EMCCD comprising a plurality of gain registers, an EMCCD comprising only one gain register, a normal CCD, a CMOS chip, an APD array or a multichannel plate.

38. Method according to Claim 37, **characterized in that** the employed photosensor chip is a line array or an area array.

## Revendications

1. Microscope à balayage confocal (1) comprenant au moins une source de lumière (3) qui émet un rayon lumineux d'éclairage (5), lequel éclaire un échantillon (10) à travers l'optique (9) par le biais d'un dispositif de balayage ponctuellement, à la manière d'une grille de points ou ligne par ligne, un élément dispersif (20), qui dissocie spectralement dans l'espace un rayon de lumière de détection (12) émanant de l'échantillon (10) et le dirige sur une zone photosensible d'une puce de capteur photoélectrique (19),
**caractérisé en ce qu'**une source de lumière de référence (30) est présente, laquelle dirige de la lumière sur au moins une partie de la puce de capteur photoélectrique, et **en ce qu'**une unité de commande et de régulation est présente, laquelle détermine et corrige des variations entre les éléments photosensibles individuels, soit l'unité de commande et de régulation étant configurée de telle sorte que la mesure de référence est effectuée pendant un trajet de retour ou dans des points de changement de direction du dispositif de balayage, soit la source de lumière de référence éclairant un nombre limité des éléments photosensibles de la puce de capteur photoélectrique, lesquels n'apportent aucune contribution à la mesure proprement dite.

2. Microscope (1) selon la revendication 1, **caractérisé en ce que** la source de lumière de référence éclaire tous les éléments photosensibles de la puce de capteur photoélectrique.

3. Microscope (1) selon l'une des revendications 1 et 2, **caractérisé en ce que** la source de lumière de référence définit un trajet de rayon de référence, et un rayon de détection est dirigé sur la puce de capteur photoélectrique, le trajet de rayon de détection et le trajet de rayon de référence étant partiellement identiques.

4. Microscope (1) selon l'une des revendications 1 et 2, **caractérisé en ce que** la source de lumière de référence définit un trajet de rayon de référence, et un rayon de détection est dirigé sur la puce de capteur photoélectrique, le trajet de rayon de détection et le trajet de rayon de référence étant séparés dans l'espace.

5. Microscope (1) selon la revendication 4, **caractérisé en ce qu'**une roue à filtre se trouve dans le trajet de rayon de référence.

6. Microscope (1) selon l'une des revendications 1 à 4, **caractérisé en ce qu'**un masque se trouve dans le trajet de rayon de référence afin d'éclairer des éléments photosensibles choisis de la puce de capteur photoélectrique.

7. Microscope (1) selon l'une des revendications 1 à 6, **caractérisé en ce que** la source de lumière de référence est une source de lumière ponctuelle.

8. Microscope (1) selon l'une des revendications 1 à 6, **caractérisé en ce qu'**un diaphragme perforé est monté en aval de la source de lumière de référence afin de générer une source de lumière ponctuelle.

9. Microscope (1) selon la revendication 8, **caractérisé en ce que** le diaphragme perforé est un diaphragme perforé fixe.

10. Microscope (1) selon la revendication 8, **caractérisé en ce que** le diaphragme perforé est un diaphragme perforé variable.

11. Microscope (1) selon l'une des revendications 1 à 10, **caractérisé en ce que** la lumière de la source de lumière de référence peut être mise en circuit et hors circuit de telle sorte que soit seule la lumière du trajet de rayon de détection, soit seule la lumière du trajet de rayon de référence est incidente sur la puce de capteur photoélectrique.

12. Microscope (1) selon l'une des revendications 1 à 11, **caractérisé en ce que** la lumière de la source de lumière de référence peut être allumée et éteinte par le biais de l'unité de commande ou de régulation.

13. Microscope (1) selon la revendication 12, **caractérisé en ce que** la source de lumière de référence est une LED ou une diode laser.

14. Microscope (1) selon l'une des revendications 1 à 13, **caractérisé en ce qu'**un filtre commutable est présent, avec lequel l'intensité lumineuse de la lumière de référence peut être réglée par le biais de l'unité de commande ou de régulation.

15. Microscope (1) selon la revendication 14, **caractérisé en ce que** le filtre commutable est un élément opto-acoustique, un élément optoélectronique ou un afficheur à cristaux liquides.

16. Microscope (1) selon l'une des revendications 1 à 15, **caractérisé en ce que** l'unité de commande ou de régulation effectue une correction des différentes amplifications des éléments photosensibles de la puce de capteur photoélectrique après l'amplification du signal par les éléments photosensibles de la puce de capteur photoélectrique.

17. Microscope (1) selon l'une des revendications 1 à 15, **caractérisé en ce que** l'unité de commande ou de régulation effectue une correction des différentes amplifications des éléments photosensibles de la puce de capteur photoélectrique par régulation individuelle de l'amplification du signal par les éléments photosensibles de la puce de capteur photoélectrique.

18. Microscope (1) selon l'une des revendications 1 à 16, **caractérisé en ce que** la puce de capteur photoélectrique est un EMCCD à plusieurs registres amplificateurs, un EMCCD avec un seul registre amplificateur, un CCD normal, une puce CMOS, un réseau APD ou une plaque multicanaux.

19. Microscope (1) selon la revendication 18, **caractérisé en ce que** la puce de capteur photoélectrique utilisée est un réseau de lignes ou un réseau de surface.

20. Procédé d'étalonnage d'une puce de capteur photoélectrique dans un microscope à balayage confocal, qui comporte une pluralité d'éléments photosensibles, **caractérisé en ce qu'**un rayon de lumière de référence est émis par une source de lumière de référence, le rayon de lumière de référence étant dirigé sur au moins une partie de la puce de capteur photoélectrique, et **en ce qu'**une unité de commande ou de régulation est présente, par le biais de laquelle sont déterminées et corrigées des variations entre les éléments photosensibles individuels, soit la mesure de référence étant effectuée pendant un trajet de retour ou dans des points de changement de direction du dispositif de balayage, soit la source de lumière de référence éclairant un nombre limité des éléments photosensibles de la puce de capteur photoélectrique, lesquels n'apportent aucune contribution à la mesure proprement dite.

21. Procédé selon la revendication 20, **caractérisé en ce que** tous les éléments photosensibles de la puce de capteur photoélectrique sont éclairés par la source de lumière de référence.

22. Procédé selon l'une des revendications 20 et 21, **caractérisé en ce que** la source de lumière de référence définit un trajet de rayon de référence, et un rayon de détection est dirigé sur la puce de capteur photoélectrique, le trajet de rayon de détection et le trajet de rayon de référence étant partiellement identiques.

23. Procédé selon l'une des revendications 20 et 21, **caractérisé en ce que** la source de lumière de référence définit un trajet de rayon de référence, et un rayon de détection est dirigé sur la puce de capteur photoélectrique, le trajet de rayon de détection et le trajet de rayon de référence étant séparés dans l'espace.

24. Procédé selon la revendication 23, **caractérisé en ce qu'**une roue à filtre se trouve dans le trajet de rayon de référence.

25. Procédé selon l'une des revendications 20 à 24, **caractérisé en ce qu'**un masque se trouve dans le trajet de rayon de référence, de sorte que des éléments photosensibles choisis de la puce de capteur photoélectrique sont éclairés.

26. Procédé selon l'une des revendications 20 à 24, **caractérisé en ce qu'**un réseau constitué de miroirs microélectroniques se trouve dans le trajet de rayon de référence, de sorte que des éléments photosensibles choisis de la puce de capteur photoélectrique sont éclairés.

27. Procédé selon l'une des revendications 20 à 26, **caractérisé en ce que** la source de lumière de référence est une source de lumière ponctuelle.

28. Procédé selon l'une des revendications 20 à 26, **caractérisé en ce qu'**un diaphragme perforé est monté en aval de la source de lumière de référence afin de générer une source de lumière ponctuelle.

29. Procédé selon la revendication 28, **caractérisé en ce que** le diaphragme perforé est un diaphragme perforé fixe.

30. Procédé selon la revendication 25, **caractérisé en ce que** le diaphragme perforé est un diaphragme perforé variable.

31. Procédé selon l'une des revendications 20 à 30, **caractérisé en ce que** la lumière de la source de lumière de référence est mise en circuit et hors circuit de telle sorte que soit seule la lumière du trajet de rayon de détection, soit seule la lumière du trajet de rayon de référence est incidente sur la puce de capteur photoélectrique.

32. Procédé selon l'une des revendications 20 à 31, **caractérisé en ce que** la lumière de la source de lumière de référence est allumée ou éteinte par le biais de l'unité de commande ou de régulation.

33. Procédé selon la revendication 32, **caractérisé en ce que** la source de lumière de référence est une LED ou une diode laser.

34. Procédé selon l'une des revendications 20 bis 33, **caractérisé en ce qu'**un filtre commutable est présent, avec lequel l'intensité lumineuse de la lumière de référence est réglée par le biais de l'unité de commande ou de régulation.

35. Procédé selon l'une des revendications 20 à 34, **caractérisé en ce que** l'unité de commande ou de régulation effectue une correction des différentes amplifications des éléments photosensibles de la puce de capteur photoélectrique après l'amplification du signal par les éléments photosensibles de la puce de capteur photoélectrique.

36. Procédé selon l'une des revendications 20 à 34, **caractérisé en ce que** l'unité de commande ou de régulation effectue une correction des différentes amplifications des éléments photosensibles de la puce de capteur photoélectrique par régulation individuelle de l'amplification du signal par les éléments photosensibles de la puce de capteur photoélectrique.

37. Procédé selon l'une des revendications 20 à 36, **caractérisé en ce que** la puce de capteur photoélectrique est un EMCCD à plusieurs registres amplificateurs, un EMCCD avec un seul registre amplificateur, un CCD normal, une puce CMOS, un réseau APD ou une plaque multicanaux.

38. Procédé selon la revendication 37, **caractérisé en ce que** la puce de capteur photoélectrique utilisée est un réseau de lignes ou un réseau de surface.
